# EUROPEAN PATENT APPLICATION

(11) **EP 3 285 553 A1**
(43) Date of publication of application: **21.02.2018**
(21) Application number: 16306063.5
(22) Date of filing: 17.08.2016
(51) Int. Cl.: H05K 1/02, H01P 1/12, H05K 3/32, H01H 1/26, H01H 1/58, H01R 12/52

(54) **INTERCONNECTION ELEMENT, CIRCUIT BOARD COMPRISING AN INTERCONNECTION ELEMENT, ELECTRONIC DEVICE COMPRISING A CIRCUIT BOARD**

(71) Applicant: Thomson Licensing, 92130 Issy-les-Moulineaux (FR)
(72) Inventor: LO HINE TONG, Dominique, 35576 Cesson-Sévigné (FR); MORIN, Pierre-Marie, 35576 Cesson-Sévigné (FR); LE FOULGOC, Jean-Marc, 35576 Cesson-Sévigné (FR)
(74) Representative: Huchet, Anne

(57) **Abstract**

An interconnection element (255) is described including a first part (405) for connection to a first port of a transmission line (205) and a second flexible part (410) for connection to a second port of the transmission line (210), wherein in a first operating mode the first part is fixed to the first port and the second flexible part is biased such that it contacts the second port to interconnect the first and second port via the interconnection element; and in a second operating mode the first part is fixed to the first port and the second flexible part is forced away (105, 240) against the bias from the second port such that an open circuit is created between the first port and the second port.

## Description

### FIELD

The present disclosure is directed to a flexible interconnection element and a circuit board provided with a flexible interconnection element. Application of embodiments may be applied for example to the design of radio frequency (RF) boards that enables testing of characteristics of portions of the board without complex testing probes.

### BACKGROUND

This section is intended to introduce the reader to various aspects of art, which may be related to the present embodiments that are described below. This discussion is believed to be helpful in providing the reader with background information to facilitate a better understanding of the various aspects of the present disclosure. Accordingly, it should be understood that these statements are to be read in this light.

The proposed device is directed to the design of radio frequency (RF) boards. The proposed design enables testing of characteristics of portions (parts) of the RF board without increasing drastically the Bill-Of-Materials (BOM) and without using complex testing probe design.

Because of their criticality, RF systems embedded on a circuit board (for example, printed circuit boards (PCBs)) must be fully tested in production. Testing ensures that the RF boards both function and perform in compliance with the specifications. Tests are performed either by a high level Go-no-Go test or because some calibrations (of gain, power etc.) are needed, by more intense function and performance tests.

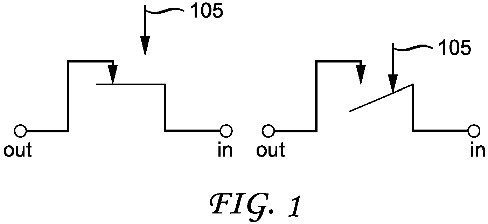

In home-networking devices, gateways, routers, bridges, brouters and set-top-boxes, RF systems deal mainly with wireless systems, such as Wi-Fi, ZigBee, Bluetooth, cellular 3G/4G networks etc. ZigBee is an IEEE 802.15.4-based specification for a suite of high-level communication protocols used to create personal area networks with small, low-power digital radios. In production, each transmit/receive chain of these systems must be tested and the tests are performed by permanently inserting a switch (SW) connector between the RF transmit/receive chain and its related (attached) antenna. Most of the SW connectors are based on the principle illustrated in Fig. 1. Specifically, the SW connector is a surface mounted device (SMD) 2-port component inserted in an RF transmit/receive chain, typically between the antenna and the chipset circuit. In normal operating mode (without testing probe), the two ports are short-circuited, thus signal coming from port IN is directed towards port OUT and vice-versa. However, in testing mode, signal coming from port IN is directed towards the probe while port OUT is left as an open-circuit. Specifically, the circuit on the left side of Fig. 1 is a circuit without the coaxial probe 105 inserted for testing. The circuit on the right side of Fig. 1 is a circuit with the coaxial probe 105 inserted for testing. The circuit on the right side of Fig. 1 with the probe inserted results in a disconnection between the input (IN) and the output (OUT) thereby causing an open circuit.

Because wireless systems are increasingly embedded in home-networking devices, more and more SW connectors will be needed, increasing significantly the BOM cost. A more cost effective solution to testing SW connectors would be useful.

A new solution is proposed herein with the advantages of being more compact and easier to apply.

### SUMMARY

In order to enable the testing of RF boards at very low cost, instead of using costly SW connectors, the proposed device inserts a 2-port flexible metal element on the RF transmit/receive trace to be tested, this trace being preferably printed on the bottom side of a PCB. Then, in normal operating mode, the flexible metal element interconnects both sides of the RF transmit/receive trace, while in testing mode by using a coaxial probe, one side of the RF transmit/receive trace is connected to the probe leaving the second side in open-circuit.

An interconnection element is described including a first part for connection to a first port of a transmission line and a second flexible part for connection to a second port of the transmission line, wherein in a first operating mode the first part is fixed to the first port and the second flexible part is biased such that it contacts the second port to interconnect the first and second port via the interconnection element; and in a second operating mode the first part contacts the first port and the second flexible part is forced away against the bias from the second port such that an open circuit is created between the first port and the second port.

In another embodiment of the interconnection element a first end of the interconnection element is formed in a U-shape, the first part being one side of the U and having a first flat surface for being fixed to the first port.

In another embodiment of the interconnection element the second part has a second flat surface for contact with the second port, the second flat surface being larger than said first flat surface.

In another embodiment the interconnection element is less than 3 mm in length.

In another embodiment the interconnection element is flexible and metal.

In another embodiment of the interconnection element, the second flat surface is at a same height as the first flat surface.

In an embodiment a circuit board includes an interconnection element, wherein each port of the transmission line is terminated by a dedicated pad of the circuit board.

In another embodiment the circuit board includes the interconnection element and the first end of the interconnection element is adhered to a first pad of the first port of the circuit board and the second flat surface of the interconnection element is in contact with a second pad of the second port of the circuit board, the first pad and the second pad being disposed on a bottom layer of the circuit board.

In another embodiment of the circuit board, a hole is drilled above the second pad of the circuit board, wherein the hole is un-metalized.

In another embodiment the circuit board includes a first port of the transmission line, which is connected to a wireless circuit and a second port of the transmission line, which is connected to an antenna.

In another embodiment a second inner layer of the circuit board includes a ground plane and a first aperture above the first pad.

In another embodiment the circuit board includes a first inner layer and a top layer both of which include a ground plane, the circuit board further includes a second aperture above the second pad, the second aperture is in the second inner layer and the top layer.

In another embodiment of the circuit board, the second aperture in the second inner layer and the top layer is circular and the first aperture is rectangular.

In another embodiment of the circuit board, the second flat surface is larger than the first flat surface.

In another embodiment an electronic device includes a circuit board and an interconnection element.

### BRIEF DESCRIPTION OF THE DRAWINGS

The proposed method and apparatus is best understood from the following detailed description when read in conjunction with the accompanying drawings. The drawings include the following figures briefly described below:
Fig. 1 illustrates the testing concept when using an RF switch connector.
Fig. 2 is an exemplary embodiment of the proposed interconnection device in normal operating mode in accordance with the principles described herein.
Fig. 3 is an exemplary embodiment of the proposed interconnection device in testing mode in accordance with the principles described herein.
Fig. 4a is a 3D view of the proposed interconnection device in accordance with the principles described herein.
Fig. 4b is a cross-sectional view of the proposed interconnection device in accordance with the principles described herein.
Fig. 5 is a view of the bottom layer design of the proposed interconnection device in accordance with the principles described herein.
Fig. 6 is a top view of the bottom layer design with the proposed flexible metal interconnection device in accordance with the principles described herein.
Fig. 7 is a view of the bottom layer with the inner layer 2 of the proposed interconnection device in accordance with the principles described herein.
Fig. 8 is a view of the bottom layer with inner layer 2 and inner layer 1 of the proposed interconnection device in accordance with the principles described herein.
Fig. 9 is a view of a cut plane along the longitudinal axis of the proposed interconnection device and PCB in accordance with the principles described herein.
Fig. 10 is a perspective view of the entire structure in accordance with the principles described herein.
Fig. 11 shows the return loss response of the entire structure.

It should be understood that the drawing(s) are for purposes of illustrating the concepts of the disclosure and is not necessarily the only possible configuration for illustrating the disclosure.

### DETAILED DESCRIPTION

The present description illustrates the principles of the present disclosure. It will thus be appreciated that those skilled in the art will be able to devise various arrangements that, although not explicitly described or shown herein, embody the principles of the disclosure and are included within its scope.

All examples and conditional language recited herein are intended for educational purposes to aid the reader in understanding the principles of the disclosure and the concepts contributed by the inventor to furthering the art, and are to be construed as being without limitation to such specifically recited examples and conditions.

Moreover, all statements herein reciting principles, aspects, and embodiments of the disclosure, as well as specific examples thereof, are intended to encompass both structural and functional equivalents thereof. Additionally, it is intended that such equivalents include both currently known equivalents as well as equivalents developed in the future, i.e., any elements developed that perform the same function, regardless of structure.

Thus, for example, it will be appreciated by those skilled in the art that the block diagrams presented herein represent conceptual views of illustrative circuitry embodying the principles of the disclosure. Similarly, it will be appreciated that any flow charts, flow diagrams, state transition diagrams, pseudocode, and the like represent various processes which may be substantially represented in computer readable media and so executed by a computer or processor, whether or not such computer or processor is explicitly shown.

Other hardware, conventional and/or custom, may also be included. Similarly, any switches shown in the figures are conceptual only. Their function may be carried out through the operation of program logic, through dedicated logic, through the interaction of program control and dedicated logic, or even manually, the particular technique being selectable by the implementer as more specifically understood from the context.

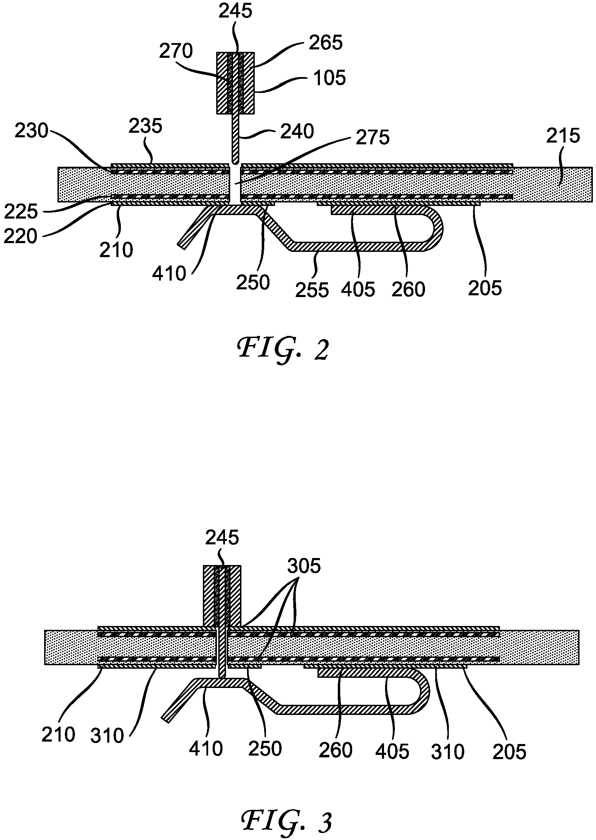

Fig. 2 and Fig. 3 show a schematic and cross-sectional view of the invention. Fig. 2 is an exemplary embodiment of the proposed interconnection device in normal operating mode. Fig. 3 is an exemplary embodiment of the proposed interconnection device in testing mode. It is preferable that a multilayer PCB is used and the circuit to be tested is printed on the bottom layer.

The proposed interconnection device is a flexible metal element 255 to interconnect the two ports, P1 205 and P2 210, of a transmission line 310 printed on a circuit board PCB 215. It is assumed that P1 205 is connected to a wireless circuit to be tested and P2 210 is connected to the antenna (which is not shown). Each port, P1 205 and P2 210, is terminated by a dedicated pad, respectively PAD1 260 and PAD2 250. A first end of the metal element is adhered (e.g., soldered) to PAD1 260, while a second end, the flexible part, is in contact with PAD2 250 thanks to a spring effect. A hole 275 is drilled in the circuit board (PCB) 215 above PAD2 250 and this hole is left non-metallized.

Thus, in normal operating mode, a signal coming from P1 205 is transmitted to P2 210 via the flexible metal interconnection element 255 and vice versa. A dedicated land pattern (footprint) of the component is designed since in the RF domain the metal element will affect the impedance matching of the transmitted signal. In testing mode, a common coaxial probe 105 including an inner cylindrical conductor 270 and outer cylindrical conductor 265, with a dielectric material isolating both, is used. The inner cylindrical conductor 270 extending the coaxial structure (outer pin) is then inserted in the circuit board (PCB) hole 275.

The length of the outer pin is set to be equal to the PCB thickness plus a few tenths of a millimeter, just long enough to push on the flexible part of the metal interconnection device (see Fig. 3) and to disconnect the flexible metal interconnection device from PAD2 250. Once the coaxial probe 105 is fully plugged into the hole, the probe outer conductor (the ground of the coaxial structure) is then in contact with the PCB ground plane 305. Thus, the signal coming from port P1 205 is then transmitted to the probe output P3 245 through outer pin 240 of the coaxial probe 105. The coaxial probe 105 can be terminated by a classical SubMiniature version A (SMA connector), which is a type of coaxial RF connector.

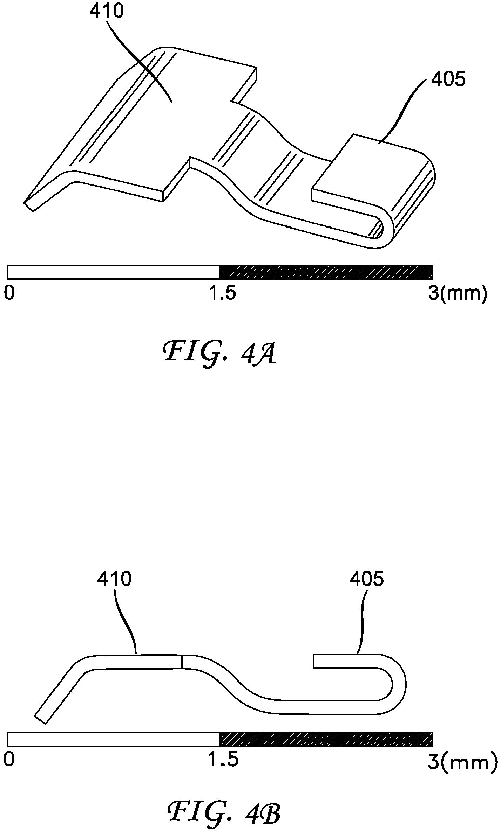

The whole circuit as shown in Fig. 2 has been simulated using the 3D electromagnetic simulation tool HFSS™. The PCB is a 4-layer fiberglass reinforced epoxy (FR4-base) substrate, with a total thickness of 1.2 mm, a thickness between the top layer 235 and inner 1 layer 230, and between the bottom layer 220 and inner 2 layer 225, of 0.12mm. The whole designed and simulated structure is shown in Figs. 4 to 10.

Fig. 4a is a 3D view of the proposed interconnection device in accordance with an embodiment. Fig. 4b is a cross-sectional view of the proposed interconnection device. On the right side of the proposed interconnection device is a first part comprising a flat metal surface 405 designed to be adhered (e.g., soldered) to PAD1 260 of the circuit board (PCB) 215. The proposed interconnection device is then bent by 180° to form a U-shape. The extending part (leg) of the interconnection device is then raised to a height corresponding to the first surface to form (present) a second surface 410 that will be in contact with the PAD2 250 of the circuit board (PCB) 215. The second surface also offers the required flexibility when the probe outer pin 240 presses down the second surface. This second part/end/ surface 410 is relative wide in order to enable this flexibility, to ensure reliable contact with PAD2 250 of the circuit board (PCB) 215 in operating mode and to ensure reliable contact with the probe outer pin 240 in testing mode. The first surface and the second surface are preferably flat for maximum contact.

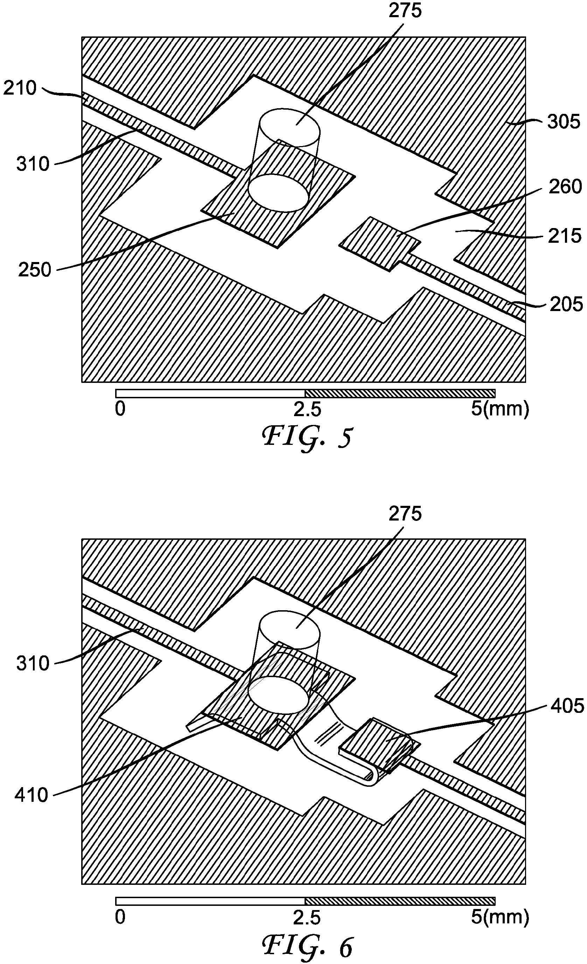

Fig. 5 shows the land pattern of metal interconnection device with the two pads, PAD1 260 and PAD2 250, printed on the bottom layer of circuit board 215 having ground plane 305. An appropriate ground clearance around the pads is designed here in order to avoid component to ground plane coupling and to mitigate impedance mismatching. A through hole 275 is drilled in the circuit board (PCB) above PAD2 250 for the insertion of the probe outer pin 240. The through hole 275 is un-metalized (non-metalized). Also shown is transmission line 310 having port P1 205 and port P2 210.

Fig. 6 is a top view of the bottom layer design with the proposed flexible metal interconnection device. Fig. 6 shows the metal interconnection device soldered to PAD1 260 of the PCB 215 and in contact with PAD2 250 of the PCB 215. The flexible metal interconnection device 255 has a first flat surface 405 and a second flat surface 410. Also shown is transmission line 310 and through hole 275.

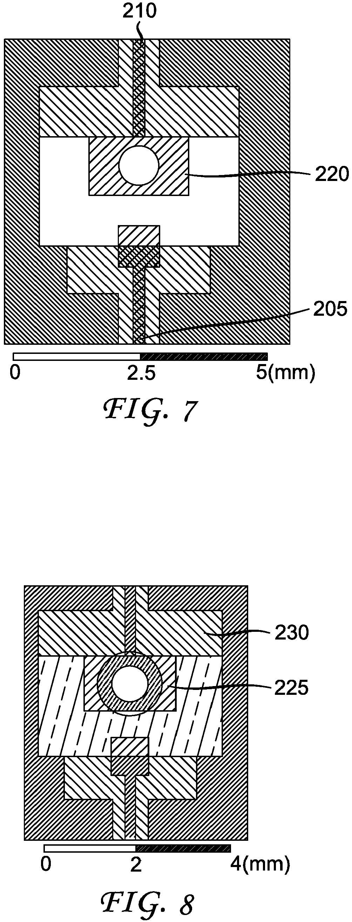

Fig. 7 is a view of the bottom layer 220 with the inner layer 2 225 of the proposed interconnection device. Fig. 7 shows the inner 2 layer 225 design that includes a ground plane with a rectangular aperture above the two pads, PAD1 260 and PAD2 250. The aperture size and positioning have been optimized in order to provide a very wide band impedance matching. Also shown are ports P1 205 and P2 210.

Fig. 8 is a view of the bottom layer 220 with inner layer 2 225 and inner layer 1 230 of the proposed interconnection device. In the upper layer, in inner layer 1 230 and the top layer 235, there is just a ground plane 305 with a circular aperture above the pad PAD2 250 and around the probe outer pin 240. Diameter of this circular aperture will depend on the dimensions of the testing probe 105, since the outer cylindrical conductor 265 of the probe 105 will be in contact with the edge of the aperture.

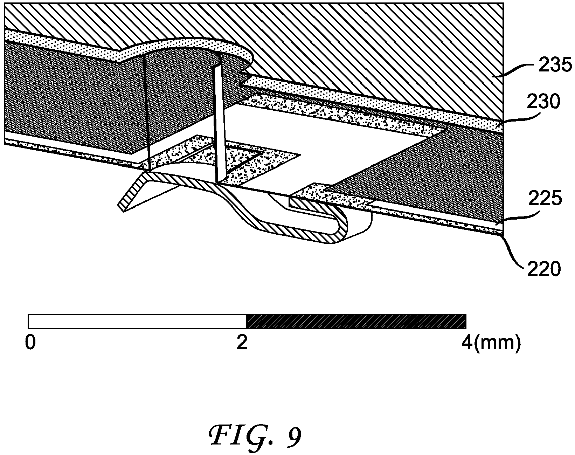

Fig. 9 is a view of a cut plane along the longitudinal axis of the proposed flexible metal interconnection device 255 and PCB 215. First flat surface 405 of the flexible metal interconnection device 255 is adhered to the bottom layer 220 of circuit board (PCB) 215. Second flat surface 410 of the flexible metal interconnection device 255 is in contact with the bottom layer 220 of circuit board (PCB) 215. Also shown is inner layer 2 225, inner layer 1 230 and top layer 235 of circuit board (PCB) 215.

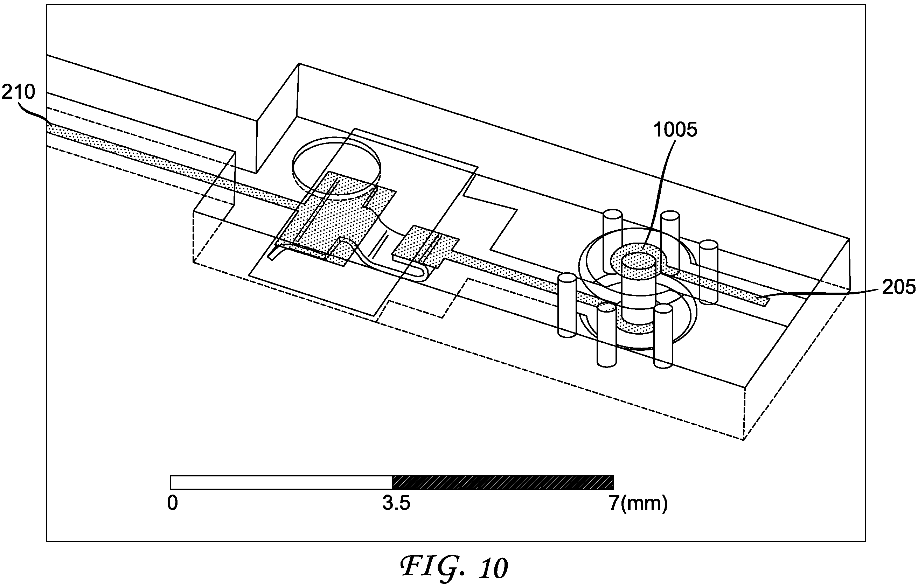

Fig. 10 is a perspective view of the entire structure. Additionally, assuming now the chip set circuit in placed on the top layer 235, with thus P1 205 on the top layer 235 as depicted in Fig. 10, then RF-via metallized hole 1005 design, having a semi coaxial structure, is used to transmit the signal from the top layer 235 to the bottom layer 220.

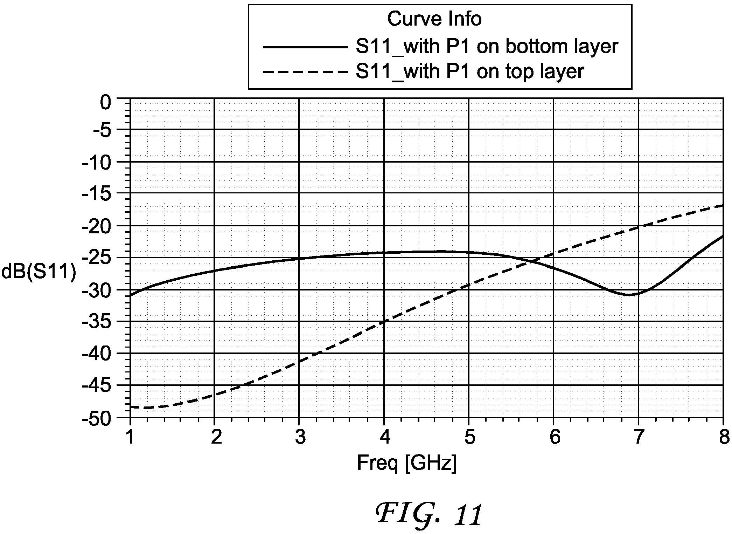

Fig. 11 shows the return loss response of the entire structure. Both the flexible metal interconnection device and the PCB 215 with P2 210 on the bottom layer 220 and P1 205 on the top layer 235 plus the RF-via metalized hole 1005, have been fully simulated. The design is well matched in a very wide frequency band, whatever the configuration, with a return loss level lower than -20dB up to 7GHz, covering thus all wireless applications embedded in a set-top-box or a gateway, in particular WLAN based on the popular IEEE.802.11 a/b/g/n/ac standard.

Embodiments of the invention can enable the testing of RF boards at reduced cost, avoiding for example the use of costly SW connectors.

For purposes of this application and the claims, using the exemplary phrase "at least one of A, B and C," the phrase means "only A, or only B, or only C, or any combination of A, B and C."

## Claims

1. An interconnection element, comprising:
a first part for connection to a first port of a transmission line and a second flexible part for connection to a second port of the transmission line; wherein
in a first operating mode the first part (405) is fixed to the first port and the second flexible part (410) is biased such that it contacts the second port to interconnect the first and second port via the interconnection element; and
in a second operating mode the first part is fixed to the first port and the second flexible part (410) is forced away against the bias from the second port such that an open circuit is created between the first port and the second port.

2. The interconnection element according to claim 1 wherein a first end of the interconnection element is formed in a U-shape, the first part being one side of the U and having a first flat surface for being fixed to the first port.

3. The interconnection element according to claim 1 or 2 wherein the second part has a second flat surface for contact with the second port, the second flat surface (410) being larger than said first flat surface (405).

4. The interconnection element according to any of said preceding claims, wherein said interconnection element is less than 3 mm in length.

5. The interconnection element according to any of the preceding claims, wherein said interconnection element is flexible and metal.

6. The interconnection element according to 3, wherein said second flat surface is at a same height as said first flat surface.

7. A circuit board (215) comprising an interconnection element according to any preceding claim, and a transmission line wherein each port (205, 210) of the transmission line (310) is terminated by a dedicated pad (250, 260) of the circuit board (215).

8. The circuit board (215) according to claim 7, wherein said first end of said interconnection element is adhered to a first pad (260) of said first port of said circuit board (215) and said second flat surface (410) of said interconnection element is in contact with a second pad (250) of said second port of said circuit board (215), said first pad (260) and said second pad (250) being disposed on a bottom layer (220) of said circuit board (215).

9. The circuit board according to any one of claims 7 or 8, wherein a hole (275) is drilled above said second pad (250) of said circuit board (215) and wherein said hole (275) is un-metalized.

10. The circuit board according to any one of claims 7 to 9, wherein the first port (205) of said transmission line (310) of said circuit board is connected to a wireless circuit and the second port (210) of said transmission line (310) of said circuit board is connected to an antenna.

11. The circuit board according to any of one claims 8 to 10, wherein a second inner layer (225) of said circuit board (215) includes a ground plane (305) and a first aperture above said first pad (260) of said circuit board and above said second pad (250) of said circuit board.

12. The circuit board according to any one of claims 7 to 11, wherein a first inner layer (230) and a top layer (235) of said circuit board (215) each include the ground plane (305) and said circuit board further includes a second aperture above said second pad (250) of said circuit board, the second aperture is in the second inner layer (225) of said circuit board and the top layer (235) of said circuit board.

13. The circuit board according to claim 12, wherein said second aperture of said circuit board in said second inner layer (225) and said top layer (235) and is circular and wherein said first aperture of said circuit board is rectangular.

14. An electronic device comprising a circuit board according to any one of claims 5 to 13.
